(19) Europäisches Patentamt
European Patent Office
Office européen des brevets

(11) **EP 3 144 964 A1**

(12) **EUROPEAN PATENT APPLICATION**
published in accordance with Art. 153(4) EPC

(43) Date of publication:
**22.03.2017 Bulletin 2017/12**

(51) Int Cl.:
*H01L 21/3205* (2006.01)    *C08K 3/08* (2006.01)
*C08L 65/00* (2006.01)    *H01L 21/768* (2006.01)
*H01L 23/522* (2006.01)    *H01L 23/532* (2006.01)
*H01L 25/065* (2006.01)    *H01L 25/07* (2006.01)
*H01L 25/18* (2006.01)

(21) Application number: 15792649.4

(22) Date of filing: **14.05.2015**

(86) International application number:
**PCT/JP2015/063860**

(87) International publication number:
**WO 2015/174482 (19.11.2015 Gazette 2015/46)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **16.05.2014 JP 2014102210**

(71) Applicant: **National Institute for Materials Science
Tsukuba-shi, Ibaraki 305-0047 (JP)**

(72) Inventors:
• **KAWAKITA Jin
Tsukuba-shi
Ibaraki 305-0047 (JP)**

• **HORVATH Barbara
Tsukuba-shi
Ibaraki 305-0047 (JP)**
• **CHIKYO Toyohiro
Tsukuba-shi
Ibaraki 305-0047 (JP)**

(74) Representative: **Calamita, Roberto
Dehns
St Bride's House
10 Salisbury Square
London
EC4Y 8JD (GB)**

(54) **SILVER DIFFUSION BARRIER MATERIAL, SILVER DIFFUSION BARRIER, AND SEMICONDUCTOR DEVICE USING SAME**

(57)    By using silicon oxynitride with an oxygen content of 4.2 to 37.5 at% as a material for a barrier layer, adhesiveness similar to that of silicon oxide and an Ag diffusion prevention property similar to that of silicon nitride can be realized. In particular, in a semiconductor device in which a plurality of silicon chips is vertically stacked by through-silicon vias, Ag is prevented from being diffused into Si and adhesiveness to Si becomes favorable when an Ag/polypyrrole complex is used as a conductive filling material used for the formation of a barrier layer provided on the inner surface of the via.

Fig. 8a

**Description**

Technical Field

The present invention relates to a silver diffusion barrier material which prevents diffusion of silver (Ag) into silicon (Si) and a silver diffusion barrier using the material, and further relates to a semiconductor device using the barrier.

Background Art

As a direct consequence of Moore's law, there is a continuing demand for higher-density packaging and lower electric energy consumption, and thus it is considered that downsizing of LSI for performance improvement will reach the limit in no distant future. To further advance the integration of LSI, chips are vertically stacked. This is called 3D-LSI. There are a large number of methods of connecting chips (for example, wire bonding), but the latest and most effective method is to bring layers into direct contact with each other. A key technique for realizing this is a through-silicon via (TSV). In the TSV, conductive electric wires are provided in the form of vias in the vertical direction between LSI chips (Non Patent Literature 1).

Currently, a preferred method for filling a conductive material in the inner portions of these vias is copper electroplating (Non Patent Literatures 2 and 3). However, in order to complete this process, more than one hour is required including the pre-process (Non Patent Literature 4). The inventors of the present application have proposed a complex of a metal and a conductive polymer in order to solve the problem occurring when electroplating is employed and provide a higher-speed TSV filling method. In this method, an Si wafer is immersed in a solution obtained by dispersing the complex so that the complex is filled in vias of the Si wafer.

Most conductive polymers have a relatively low conductivity; however, when a complex with an additional metal such as Ag (Non Patent Literature 5), Pd (Non Patent Literature 6), or Au (Non Patent Literatures 7 and 8) is formed, favorable conductive performance can be achieved, and thus application to an electronic device becomes possible. The complex discussed in the present application causes reaction in which polypyrrole (PPy) is formed and reaction in which metallic silver is formed at the same time by oxidation polymerization of pyrrole (Py) and reductive precipitation from silver ions, and the complex is produced by using light-utilizing reaction which increases the growth rate of the complex by UV irradiation.

When Ag is combined with conductive PPy, a complex having a high electric conductivity ($2 \times 10^4$ $\Omega^{-1} \cdot cm^{-1}$) can be obtained. This electric conductivity is several hundred times higher than that of a commercially available conductive polymer (Non Patent Literature 9). Hitherto, the structure of dispersed conductive polymer-coated colloidal particles has drawn attention. This structure can change, depending on reaction conditions, from a single Ag core structure in which polypyrrole functions as the shell (Non Patent Literatures 10 to 12) to a raspberry-shaped structure in which Ag is positioned on the surface of the polymer (Non Patent Literatures 10, 13, and 14). Hitherto, a conductive Ag/PPy complex has been mainly used for a gas sensor (Non Patent Literatures 15 and 16), a catalyst (Non Patent Literatures 17 and 18), antimicrobial coating (Non Patent Literatures 19 and 20), or conductive wiring which is subjected to ink jet printing for a flexible electronic device (Non Patent Literature 5). The Ag/PPy complex conducts electricity, is flexible and inexpensive, and has sufficient adherability to a substrate. For this reason, it has been found that the Ag/PPy complex is an excellent material for electric wiring for flexible electronic devices.

By using this complex as a filling material for the TSV, the filling process can be shortened up to mere 10 minutes (Non Patent Literature 21). The Ag/PPy coating has excellent adhesiveness with several substrates such as Si and various plastic (for example, polytetrafluoroethylene (PTFE) or polyimide) substrates (Non Patent Literature 22), and thus the relevant material becomes a highly reliable candidate as a TSV material. According to the reports until now, Py and PPy exhibit favorable adhesiveness to Si (Non Patent Literature 23), and regarding the liquid dispersion degrees of Ag/PPy, average contact angles on Si and SiO$_2$ surfaces are 27.8° and 10.3°, respectively, that is, significantly favorable wettability is exhibited (Non Patent Literature 21). Such small contact angles indicate that the molecular interaction between the dispersion liquid and the substrate is strong so that favorable adhesiveness between both materials is imparted.

However, Ag nanoparticles are considered to be a material that is diffused into an Si substrate. This point may play an effective role on adhesiveness; however, these Ag nanoparticles diffused into the Si substrate cause a problem in reliability, and thus a problem arises in that the lifespan of an electronic device is likely to be shortened (Non Patent Literatures 24 to 26).

Impurity diffusion phenomenon can be prevented by using a barrier layer which prevents atoms from being diffused into a substrate. SiOx and SiNx are widely used in production of Si chips for forming the TSVs. Currently, SiO$_2$ is mainly used for covering a defect, which may be caused by via etching, and isolating a filling material from a substrate (Non Patent Literatures 27 and 28). In consideration of this point only, a natural option as a barrier used for the Ag/PPy material may be to use SiOx and SiNx. However, although SiNx has favorable barrier characteristic with respect to the diffusion of Ag (Non Patent Literatures 29 and 30), SiNx has poor adherability to a polymer (Non Patent Literature 31). Moreover, in order to improve this problematic characteristic, there is a need to provide a superfluous step (for example, a step of applying an adhesion accelerator), and in the case of performing such a step, the throughput in via production will be adversely affected. When the Ag paste is tested, SiOx has poor Ag diffusion barrier characteristics (Non Patent Literature 32). SiOxNy may have several characteristics of SiNx and SiOx, but the evaluation on this material has not been sufficiently carried out. Although limited researches on the Ag diffusion barrier characteristics of this material have been conducted (Non Patent Literature 33), details of the composition of the material are not known.

Citation List

Non Patent Literature

[Non Patent Literature 1] Motoyoshi, M., Through-Silicon Via (TSV). Proc. IEEE 2009, 97 (1), 43-48.

[Non Patent Literature 2] Okoro, C.; Vanstreels, K.; Labie, R.; Luhn, O.; Vandevelde, B.; Verlinden, B.; Vandepitte, D., Influence of annealing conditions on the mechanical and microstructural behavior of electroplated Cu-TSV. J. Micromech. Microeng 2010, 20 (4), 045032.

[Non Patent Literature 3] Kim, B.; Sharbono, C.; Ritzdorf, T.; Schmauch, D. In Factors affecting copper filling process within high aspect ratio deep vias for 3D chip stacking, Proc. Electronic Components and Technology Conference 56th, 2006; p 6 pp.

[Non Patent Literature 4] Shi, S.; Wang, X.; Xu, C.; Yuan, J.; Fang, J.; Liu, S., Simulation and fabrication of two Cu TSV electroplating methods for wafer-level 3D integrated circuits packaging. Sensor. Actuator. A: Physical 2013, 203 (0), 52-61.

[Non Patent Literature 5] Stejskal, J., Conducting polymer-silver composites. Chem. Pap. 2013, 67 (8), 814-848.

[Non Patent Literature 6] Fujii, S.; Matsuzawa, S.; Hamasaki, H.; Nakamura, Y.; Bouleghlimat, A.; Buurma, N. J., Polypyrrole-Palladium Nanocomposite Coating of Micrometer-Sized Polymer Particles Toward a Recyclable Catalyst. Langmuir 2011, 28 (5), 2436-2447.

[Non Patent Literature 7] Tamil Selvan, S., Novel nanostructures of gold-polypyrrole composites. Chem. Commun. 1998, (3), 351-352.

[Non Patent Literature 8] Henry, M. C.; Hsueh, C.-C.; Timko, B. P.; Freund, M. S., Reaction of Pyrrole and Chlorauric Acid A New Route to Composite Colloids. J. Electrochem. Soc. 2001, 148 (11), D155-D162.

[Non Patent Literature 9] Kawakita, J.; Chikyow, T., Fast Formation of Conductive Material by Simultaneous Chemical Process for Infilling Through-Silicon Via. Jpn J Appl Phys 51, 06FG11.

[Non Patent Literature 10] Jung, Y. J.; Govindaiah, P.; Choi, S. W.; Cheong, I. W.; Kim, J. H., Morphology and conducting property of Ag/poly(pyrrole) composite nanoparticles: Effect of polymeric stabilizers. Synth. Met. 2011, 161 (17-18), 1991-1995.

[Non Patent Literature 11] Shi, Z.; Wang, H.; Dai, T.; Lu, Y., Room temperature synthesis of Ag/polypyrrole core-shell nanoparticles and hollow composite capsules. Synth. Met. 2010, 160 (19-20), 2121-2127.

[Non Patent Literature 12] Dallas, P.; Niarchos, D.; Vrbanic, D.; Boukos, N.; Pejovnik, S.; Trapalis, C.; Petridis, D., Interfacial polymerization of pyrrole and in situ synthesis of polypyrrole/silver nanocomposites. Polymer 2007, 48 (7), 2007-2013.

[Non Patent Literature 13] Zhao, C.; Zhao, Q.; Zhao, Q.; Qiu, J.; Zhu, C.; Guo, S., Preparation and optical properties of Ag/PPy composite colloids. J. Photoch. Photobio. A 2007, 187 (2-3), 146-151.

[Non Patent Literature 14] Ijeri, V. S.; Nair, J. R.; Gerbaldi, C.; Gonnelli, R. S.; Bodoardo, S.; Bongiovanni, R. M., An elegant and facile single-step UV-curing approach to surface nano-silvering of polymer composites. Soft Matter 2010, 6 (19), 4666-4668.

[Non Patent Literature 15] Kabir, L.; Mandal, A. R.; Mandal, S. K., Humidity-sensing properties of conducting polypyrrole-silver nanocomposites. J. Exp. Nanosci. 2008, 3 (4), 297-305.

[Non Patent Literature 16] Kate, K. H.; Damkale, S. R.; Khanna, P. K.; Jain, G. H., Nano-Silver Mediated Polymerization of Pyrrole: Synthesis and Gas Sensing Properties of Polypyrrole (PPy)/Ag Nano-Composite. J. Nanosci. Nanotechno. 2011, 11 (9), 7863-7869.

[Non Patent Literature 17] Qin, X.; Lu, W.; Luo, Y.; Chang, G.; Sun, X., Preparation of Ag nanoparticle-decorated polypyrrole colloids and their application for H2O2 detection. Electrochem. Commun. 2011, 13 (8), 785-787.

[Non Patent Literature 18] Yao, T.; Wang, C.; Wu, J.; Lin, Q.; Lv, H.; Zhang, K.; Yu, K.; Yang, B., Preparation of raspberry-like polypyrrole composites with applications in catalysis. J. Colloid Interface Sci. 2009, 338 (2), 573-577.

[Non Patent Literature 19] Shi, Z.; Zhou, H.; Qing, X.; Dai, T.; Lu, Y., Facile fabrication and characterization of poly(tetrafluoroethylene)@polypyrrole/nano-silver composite membranes with conducting and antibacterial property. Appl. Surf. Sci. 2012, 258 (17), 6359-6365.

[Non Patent Literature 20] Firoz Babu, K.; Dhandapani, P.; Maruthamuthu, S.; Anbu Kulandainathan, M., One pot synthesis of polypyrrole silver nanocomposite on cotton fabrics for multifunctional property. Carbohydr. Polym. 2012, 90 (4), 1557-1563.

[Non Patent Literature 21] B. Horvath; J. Kawakita; Chikyow, T., Through silicon via filling methods with metal/polymer composite for three-dimensional LSI. Jpn J Appl Phys 2014, (accepted for publication).

[Non Patent Literature 22] Kawakita, J.; Hashimoto, Y.; Chikyow, T., Strong Adhesion of Silver/Polypyrrole Composite onto Plastic Substrates toward Flexible Electronics. Jpn J Appl Phys 52, 06GG12.

[Non Patent Literature 23] Seino, K.; Schmidt, W. G.; Furthmuller, J.; Bechstedt, F., Chemisorption of pyrrole and polypyrrole on Si(001). Phys. Rev. B 2002, 66 (23), 235323.

[Non Patent Literature 24] Coffa, S.; Poate, J. M.; Jacobson, D. C.; Frank, W.; Gustin, W., Determination of diffusion mechanisms in amorphous silicon. Phys. Rev. B 1992, 45 (15), 8355-8358.

[Non Patent Literature 25] Kawamoto, K.; Mori, T.; Kujime, S.; Oura, K., Observation of the diffusion of Ag atoms through an a-Si layer on Si(111) by low-energy ion scattering. Surf. Sci. 1996, 363 (1-3), 156-160.

[Non Patent Literature 26] Rollert, F.; Stolwijk, N. A.; Mehrer, H., Solubility, diffusion and thermodynamic properties of silver in silicon. J. Phys. D: Appl. Phys. 1987, 20 (9), 1148.

[Non Patent Literature 27] Klumpp, A.; Ramm, P.; Wieland, R. In 3D-integration of silicon devices: A key technology for sophisticated products, Proc. Design, Automation & Test in Europe Conference & Exhibition (DATE), 2010, 8-12 March; 2010; pp 1678-1683.

[Non Patent Literature 28] Sage, S.; John, P.; Dobritz, S.; Boernge, J.; Vitiello, J.; Boettcher, M., Investigation of different methods for isolation in through silicon via for 3D integration. Microelectron. Eng. 2013, 107 (0), 61-64.

[Non Patent Literature 29] Hoornstra, J.; Schubert, G.; Broek, K.; Granek, F.; LePrince, C. In Lead free metallisation paste for crystalline silicon solar cells: from model to results, Proc. Photovoltaic Specialists Conference, IEEE, 3-7 Jan. 2005; pp 1293-1296.

[Non Patent Literature 30] Heavy Metals - Advances in Research and Application: 2013 Edition. ScholarlyEditions: Atlanta, Georgia, 2013.

[Non Patent Literature 31] Suryanarayana, D.; Mittal, K. L., Effect of polyimide thickness on its adhesion to silicon nitride substrate with and without adhesion promoter. J. Appl. Polym. Sci. 1985, 30 (7), 3107-3111.

[Non Patent Literature 32] McBrayer, J. D.; Swanson, R. M.; Sigmon, T. W., Diffusion of Metals in Silicon Dioxide. J. Electrochem. Soc. 1986, 133 (6), 1242-1246.

[Non Patent Literature 33] Kim, H.-K.; Cho, C.-K., Transparent SiON/Ag/SiON multilayer passivation grown on a flexible polyethersulfone substrate using a continuous roll-to-roll sputtering system. Nanoscale Res. Lett. 2012, 7:69 (1), 1-6.

[Non Patent Literature 34] JIS Z1522 standard. 2009.

[Non Patent Literature 35] Hofmeister, H., Fivefold Twinned Nanoparticles. Enc. Nanosci. Nanotech. 2003, 3, 431-452.

[Non Patent Literature 36] Morita, M.; Ohmi, T.; Hasegawa, E.; Kawakami, M.; Ohwada, M., Growth of native oxide on a silicon surface. J. Appl. Phys. 1990, 68 (3), 1272-1281.

[Non Patent Literature 37] Revesz, A. G.; Evans, R. J., Kinetics and mechanism of thermal oxidation of silicon with special emphasis on impurity effects. J. Phys. Chem. Solids 1969, 30 (3), 551-564.

[Non Patent Literature 38] Dallaporta, H.; Liehr, M.; Lewis, J. E., Silicon dioxide defects induced by metal impurities. Phys. Rev. B 1990, 41 (8), 5075-5083.

[Non Patent Literature 39] Venables, J. D., Adhesion and durability of metal-polymer bonds. J. Mat. Sci. 1984, 19 (8), 2431-2453.

[Non Patent Literature 40] Bijlmer, P. F. A., Influence of Chemical Pretreatments on Surface Morphology and Bondability of Aluminium. J. Adhesion 1973, 5 (4), 319-331.

[Non Patent Literature 41] G. Ramarathnam; M. Libertucci; M. M. Sadowski; North, T. H., Joining of Polymers to Metal. Welding Journal 1992, 71 (12), 483-s-490-s.

[Non Patent Literature 42] Kozma, L.; Olefjord, I., Surface treatment of steel for structural adhesive bonding. Mater. Sci. Technol. 1987, 3 (11), 954-962.

Summary of Invention

Technical Problem

An object of the present invention is to provide a suitable barrier material having favorable adhesiveness to the Ag/PPy complex and Ag diffusion barrier characteristic, a barrier layer, and a semiconductor device using the same.

Solution to Problem

According to an aspect of the present invention, there is provided a silver diffusion barrier material including silicon oxynitride with an oxygen content ranging from 4.2 at% to 37.5 at%.

According to another aspect of the present invention, there is provided a silver diffusion barrier including the silver diffusion prevention material.

Herein, the silver diffusion barrier may be formed on a silicon substrate.

Furthermore, the silver diffusion barrier may be brought into contact with a material containing silver.

Furthermore, a thickness of the silver diffusion barrier may be 10 nm or more.

According to still another aspect of the present invention, there is provided a semiconductor device in which a plurality of silicon chips is vertically stacked by through-silicon vias, the semiconductor device including the silver diffusion barrier described in any one of the above items provided on the inner surface of the via for achieving electrical connection between the plurality of silicon chips.

Herein, a silver/polypyrrole complex material may be filled in the via provided with the silver diffusion layer.

Advantageous Effects of Invention

According to the present invention, by adjusting an amount of oxygen in silicon oxynitride, it is possible to provide a diffusion barrier material which sufficiently prevents Ag from being diffused from the Ag/PPy complex into Si and has high adhesiveness to Si, a diffusion barrier layer, and a semiconductor device using the same.

Brief Description of Drawings

Fig. 1 is a TEM image showing the structure of an interface between an Ag/PPy complex and an Si substrate.
Fig. 2 is an HRTEM image of Ag nanoparticles. FFT of a region represented by a small square at a position near the right lower side and a filtered inversed FFT image are shown as inset diagrams.
Figs. 3(a) to 3(c) are HRTEM images of Ag clusters and diffraction patterns corresponding to the images, Fig. 3(a) shows a single crystal, and Fig. 3(b) shows a poly crystal, and Fig. 3(c) shows a twin structure.
Fig. 4(a) is an HRTEM image of an Si/complex interface (native oxide therebetween), and diffused Ag is represented by the arrow. Fig. 4(b) shows a diffraction pattern corresponding to a region in which diffused Ag is present, Fig. 4(c) shows a diffraction pattern corresponding to a region in which diffused Ag is not present, Fig. 4(d) is Ag element mapping corresponding to the TEM image of Fig. 1, and Fig. 4(e) shows an EELS spectrum in an Si substrate region.
Fig. 5 is a cross-sectional HRTEM image of a formed oxide layer. Corresponding EDX values (positions P1 to P4) are presented as M1 to M4 in Table 1, respectively.
Figs. 6(a) to 6(c) are views showing the test results of the interface of an SiOx barrier layer having a thickness of 10 nm. Fig. 6(a) is a DF TEM image and the arrows indicate Ag particles. Fig. 6(b) is an Ag element map of an Si layer. Fig. 6(c) is an HRTEM image of the Si layer from a nearby position to a faraway position of a region of a complex material formed by Ag and PPy.
Figs. 7(a) to 7(c) are views showing the test results of the interface of an SiOx barrier layer having a thickness of 100 nm. Fig. 7(a) is a BF TEM image and the arrows indicate Ag particles. Fig. 7(b) is an HRTEM image of a complex/oxide interface. Fig. 7(c) is an HRTEM image of poly-crystalline and single-crystalline Ag particles in the inside of the oxide layer. FFT is shown in an inset diagram.

Fig. 8a is a TEM image of a layer having a thickness of 10 nm which shows the test result of the interface of an SiON-2 barrier layer. EDX mapping is shown in an inset diagram.
Fig. 8b is an HRTEM image of Si and a layer having a thickness of 100 nm which shows the test result of the interface of an SiON-2 barrier layer. FFT is shown in an inset diagram.
Figs. 9(a) and 9(b) are views showing the comparison result in a case where an SiOx layer, an SiON-1 layer, and an SiON-2 layer are used as barrier layers, Fig. 9(a) shows the test result of peeling strength for each layer, and Fig. 9(b) shows morphology for each layer.

Description of Embodiments

Hereinafter, embodiments of the present invention will be described.

A silver diffusion barrier material of the present invention is formed by silicon oxynitride (SiNxOy) with an oxygen content ranging from 4.2 at% to 37.5 at%, more preferably from 5 at% to 20 at%. In addition, it is desirable that the nitrogen content be 33.3 at% to 52.8 at% and more preferably 40 at% to 52.7 at%. Furthermore, the silver diffusion barrier material of the present invention is used for the formation of a silver diffusion barrier which prevents silver (Ag) from being diffused into silicon (Si), and particularly, can be preferably used in a silver/polypyrrole (Ag/PPy) complex material and exhibits more effective silver diffusion barrier performance. The silver diffusion barrier material of the present invention is filled in the inner portion of the via for electrical wiring of through-silicon vias (TSVs) particularly in a semiconductor device in which a plurality of silicon chips is vertically stacked, and is used as a silver diffusion barrier.

In silicon oxynitride serving as the silver diffusion barrier material of the present invention, when the amount of nitrogen becomes larger than the above range, silicon oxynitride becomes closer to the characteristic of silicon nitride, and thus a more complete barrier layer is obtained; however, adhesiveness to the Ag/PPy complex material is deteriorated. In addition, when the amount of oxygen becomes larger than the above range, silicon oxynitride becomes close to the characteristic of silicon oxide, and thus adhesiveness to the Ag/PPy complex material becomes higher while its Ag diffusion prevention property becomes deteriorated. Therefore, in silicon oxynitride serving as the silver diffusion barrier material of the present invention, in order to achieve the balance between the Ag diffusion prevention property and improvement in adhesiveness to the Ag/PPy complex material, it is desirable that the oxygen content be in the above range.

Furthermore, in a case where the silver diffusion barrier material of the present invention is filled in the inner portion of the via for electrical wiring of TSVs in the semiconductor device to form the silver diffusion barrier, the silver diffusion barrier preferably has a large surface roughness in order to achieve favorable adhesiveness.

When the thickness of the silver diffusion barrier material of the present invention is 10 nm or more, the silver diffusion barrier material exhibits a favorable Ag diffusion prevention property. Regarding the upper limit of the thickness, for example, in a case where the silver diffusion barrier material is used for via wiring, the practical upper limit is about 30 nm in the sense that greater thickness of the material will not significantly improve the Ag diffusion prevention property any further. Furthermore, when the thickness of the layer of the silver diffusion barrier material is at this level, the influence of the layer on the inner diameter of the via is also practically negligible.

The Ag/PPy complex material used in the present invention causes reaction in which polypyrrole is formed and reaction in which metallic silver is formed at the same time by oxidation polymerization of pyrrole and reductive precipitation from silver ions, and can be produced by using reaction utilizing light by UV irradiation. In this case, the amount of the silver ions is not particularly limited, but is preferably about 2.5 to 4 mol per 1 mol of pyrrole.

In order to use the Ag/PPy complex as a TSV filling material, it is very important to understand reaction between the complex and Si. Currently, many research reports are focused on the structural or electrical characteristics of the Ag/PPy material; however, under actual circumstances, researches on reaction between the Ag/PPy complex and another material or a substrate are not sufficiently conducted. In this regard, in order to reduce the number of process steps and improve 3D-LSI production throughput, functions of SiOx and SiNxOy as diffusion barrier layers with respect to Ag and C have been investigated.

In the following Examples, in a case where SiOx and SiOxNy with a plurality of composition combinations were provided as a barrier layer on an Si substrate, Ag diffusion prevention performance, adhesiveness of the Ag/PPy complex to the substrate, and the interface structure and various physical properties of these materials were investigated, and the compositions of the barrier layer suitable for achieving the object of the present invention were determined.

Examples

<Material and synthesis thereof>

The Ag/PPy complex was produced in the form of a dispersion liquid, and the dispersion liquid was applied to an Si substrate (sample size: $5 \times 5$ mm$^2$). Ag/PPy was synthesized by dissolving a dopant, silver nitrate ($AgNO_3$) (1.0 mol/dm$^3$) as a metal salt for an oxidant, and a pyrrole monomer (0.2 mol/dm$^3$) used for polymerization in an acetonitrile ($CH_3CN$) solvent (2.5 cm$^3$). This reaction was optically accelerated by UV irradiation (in-

tensity: 50 mW/cm$^2$, for 10 minutes) to increase a growth rate of the relevant complex. The test was carried out using four types of substrates. Specifically, a substrate having a native oxide film on Si(100), a substrate covered with an Si oxide (SiOx) barrier layer, and substrates covered with silicon oxynitride (SiON-1 and SiON-2) barrier layers were used.

In the sample with an Si oxide barrier layer (SiOx), first, SiOx was deposited on the (100) substrate by thermal oxidation (parameters: 1050°C, drying and oxidation for 30 minutes) up to an initial thickness of 200 nm, and etching was performed thereon by hydrofluoric acid (HF) until a desired thickness was obtained (parameters: HF: $NH_4F$ = 16, etching time: 30 seconds, 60 seconds, and 90 seconds). The thicknesses of SiOx formed in this way were 10 nm, 50 nm, and 100 nm, respectively.

In production of the substrate with an Si oxynitride barrier layer, first, two types of oxynitride layers SiON-1 and SiON-2 were deposited on the Si substrate by a physical vapor deposition technique (apparatus used: SHIBAURA MECHATRONICS CORPORATION, i-Miller CFE-4EP-LL), thereby producing an SiON-1 substrate (parameters: Ar 28 sccm, $N_2$ 10 sccm, DC 330 W, 0.511 Pa) and an SiON-2 substrate (parameters: Ar 18 sccm, $N_2$ 10 sccm, DC 330 W, 0.379 Pa). Similarly to the case of SiOx, the thicknesses of the produced SiON layers were 10 nm, 50 nm, and 100 nm, respectively.

The substrate with an SiOx barrier layer and the substrate with an SiOxNy barrier layer produced in this way were immersed into an Ag/PPy dispersion liquid. After the samples were taken out from the dispersion liquid, the samples were dried under external air environment.

<Measurement method and apparatus>

The composition of the barrier layer of the sample was first verified by using X-ray photoemission spectroscopy (XPS) (apparatus: Thermo Electron Corporation, Theta Probe, 3 kV) and the thickness thereof was determined by ellipsometry (J. A. Woollam M-2000). The composition itself and the structure were investigated for analysis of the structure and the interface after a dispersion solution containing a complex material was applied and dried, and then was left to stand at room temperature for 150 hours to be deposited. Regarding the adhesiveness of the complex to the substrate, six samples for each type of barrier layer were evaluated by a peeling test according to Japanese Industrial Standards (JIS) Z1522 (Non Patent Literature 34). The coat was deposited, and 24 hours later, a cellophane tape (width: 15 mm, Nichiban Co., Ltd., LP-15) was pasted on the entire surface of the test target sample, and then the cellophane tape was peeled off within 0.5 seconds in the vertical direction. The morphology of the formed complex was observed by a scanning electron microscope (SEM) (apparatus: Hitachi, Ltd., S-4800, 20 kV). The sample was observed by a focused ion beam (FIB) (apparatus: JEOL Ltd., JEM-9320FIB, 30 kV), and the microstructure and chemical composition thereof were observed by a transmission electron microscope (TEM) equipped with an energy-dispersive X-ray spectrometer (EDX), an electron energy loss spectrometer (EELS), and a selected-area electron diffractometer (SAED) (apparatus: JEOL Ltd., 2100-F, 200 kV; and FEI, Technai G2 F30, 30 kV). Before the C element was measured by EELS, the sample was subjected to the process of ion cleaning.

<Structure of Ag/PPy complex on Si>

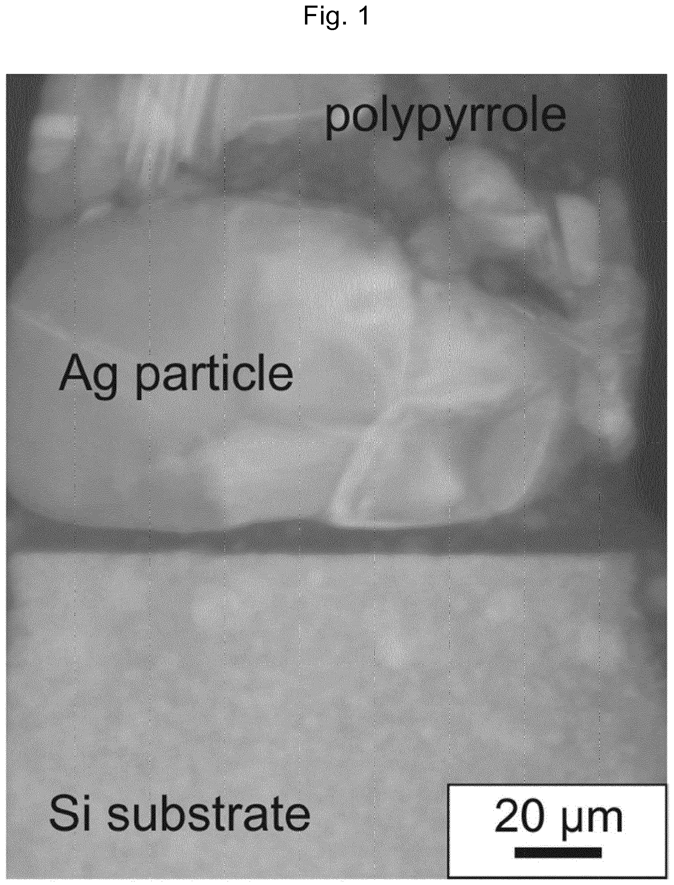

Fig. 1 shows the cross-section of the Ag/PPy complex coating which is coated on the Si surface. This complex material is mainly formed by a PPy material and Ag that is segregated in a cluster form therein. The size of the Ag clusters (that is, agglomeration of metallic silver which can be separately observed by a microscope, and practically, a complex with PPy) may be in a range from several nm to several tens of $\mu$m, and these Ag clusters are positioned in PPy at a very high density. Since a large number of Ag nanoparticles are distributed between the Ag clusters at a high density, high electric conductivity between the Ag clusters is ensured. As a result, favorable conductivity is imparted to the relevant material.

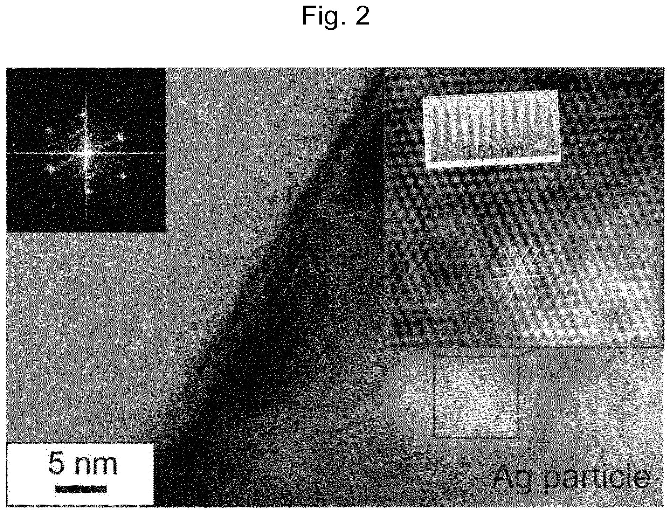

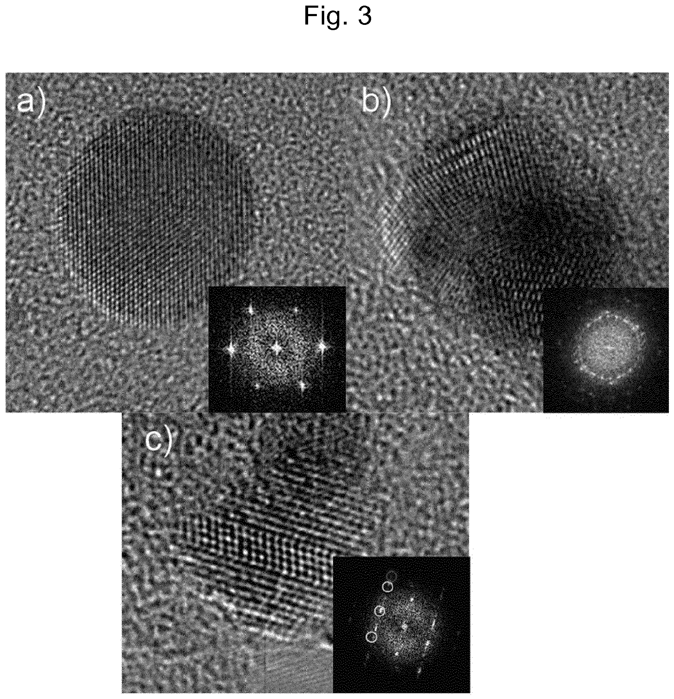

In high-resolution (HR) TEM images of Fig. 2 and Figs. 3(a) to 3(c), dark gray Ag particles and light gray PPy therearound are shown. As an EDX analysis result of the region surrounding Ag (C: 72.26 at%, N: 17.50 at%, O: 5.46 at%, Si: 2.26 at%, and Ag: 2.52 at%), the presence of a large amount of C and N at an appropriate proportion as the PPy composition is confirmed. It is found that the structure of PPy is amorphous. In order to appropriately identify the atomic structure, fast Fourier transformation (FFT), filtration process, and inverse FFT were used. As shown in Fig. 2, the FCC crystalline structure of Ag in a bulk is confirmed by the HRTEM image, and the structure of Ag nanoparticles often depends on the particle size (which is not to say that the structure thereof mainly depends on the particle size) and may be a single crystal (Fig. 3(a)) or a poly crystal (Fig. 3(b)). In the case of nanoparticles of the single crystal, the interatomic space was measured to be 0.35 nm, but this is correlated with the lattice constant of the FCC cubic crystal Ag(111) plane. The lattice constant of Ag is 3.085 A and the interval of the (111) plane is as follows:

$$b = d/2 = (a \times \sqrt{(3)})/2 = 3.537 \text{ Å.}$$

The diffraction pattern obtained by measuring the whole Ag particles represents the diffraction pattern of the (111) plane.

In some cases, as shown in Fig. 3(c), a twin structure was observed in Ag nanoparticles. The twinning in nanoparticles occurs as a result of the growth of crystals in different directions by some failures (for example, erroneous stacking of atoms) although the crystals share lattice points on the surface with other crystals. Herein, this twinning is confirmed from the diffraction pattern. In Fig. 3(c), yellow diffraction (shown by surrounding with a small white ring in the inset diagram) represents a base and red diffraction dot (shown by surrounding with a small gray ring in the inset diagram) represents a twin crystal. The twinning is involved in poly-crystalline Ag particles in some cases. The reason for this is that formation through growth can proceed by repeated twinning operations caused by erroneous stacking of atoms during growth (Non Patent Literature 35).

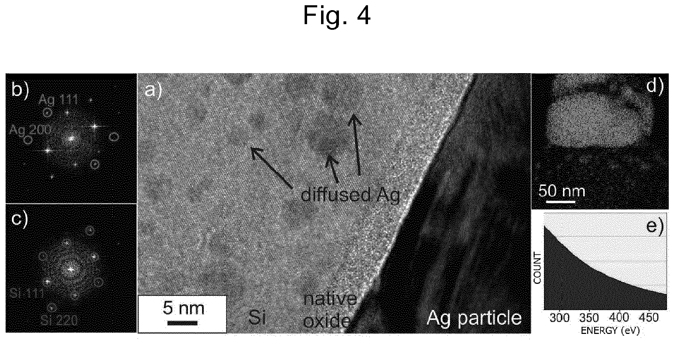

Fig. 4(a) shows a cross-sectional HRTEM image of an interface between the Ag/PPy complex and Si. The EDX analysis result of the layer structure represents that a large amount of Ag is diffused, in the form of segregated particles, in the vicinity of the interface below the surface of the Si substrate. The Ag particles were found in the substrate up to a depth of 1 to 2 $\mu$m. These Ag atoms are caused by the Ag clusters in the Ag/PPy complex. Although Ag is a substance which is diffused into Si at a high speed even at a relatively low temperature (Non Patent Literature 32), this property of Ag is used to describe how Ag passes through a thin Si oxide layer for protection. Regions of diffused Ag are shown by the arrows with description "diffused Ag" in Fig. 4(a). From the diffraction pattern, it is found that the Si substrate has a single-crystalline structure at a position in which Ag is not present, but the diffraction pattern of crystalline Ag is found at a position in which diffusion of Ag in the layer of the silicon substrate is present (Figs. 4(b) and 4(c)). In addition, when the EDS result is checked, diffraction spots of $Ag_2Si$ are not found. In general, Ag atoms are most often introduced into the space between the lattices in dislocation-free Si (Non Patent Literature 26). The segregated Ag shown in Fig. 4(d) suggests that dislocation is present in the Si substrate. The dislocation and impurities influence each other. According to this, Ag is segregated at a higher concentration in Si with dislocation rather than a dislocation-free position, and thus Ag is changed from interstitial Ag to substitutional Ag according to the theory of interstitial-substitutional diffusion mechanism.

The diffusion of C into the Si substrate was not observed in any of Si with a native oxide film, a sample with an SiOx barrier, and a sample with an SiON barrier. In some cases, a small amount of C was detected by EDX or FFT, but this C was merely derived from contamination. Ion cleaning damages the characteristics of the Ag/PPy layer. Therefore, this process had to be performed after main TEM measurement. From EELS measurement performed immediately after ion cleaning, it was found that there is no C in Si and in the barrier. The reason for this is, as understood from Fig. 4(e), that the peak of C is not observed at 284 eV in the EELS spectrum.

The Si oxide between the Si substrate and the Ag/PPy complex exhibits peculiar characteristics. When the Si substrate is exposed to air under external air en-

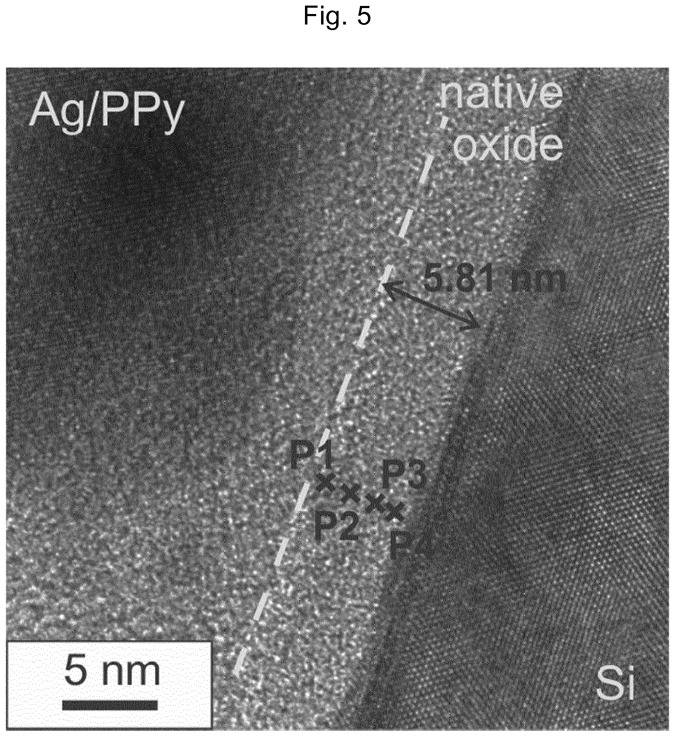

vironment, a native oxide ($SiO_2$) having a thickness of 1 nm is typically generated (Non Patent Literature 36). In this case, the sample before coating was analyzed by ellipsometry to confirm that the sample has an oxide layer having a uniform thickness of 0.98 nm. After coating, from TEM measurement, as shown in Fig. 5, it was observed that the thickness of the oxide layer was grown to be 5.8 nm. Fig. 5 shows an HRTEM image of an oxide layer, and the image represents that the inside of the layer is an amorphous layer. The EDX measurement result presented in Table 1 represents that this new oxide layer is a mixture of 60 to 80 at% of Si, 18 to 35 at% of O, and less than 1 at% of Ag, and this Ag corresponds to Ag particles passing through this layer toward the Si substrate. The specifically large thickness of the oxide as compared to the native oxidation may be caused by oxidation of Si caused by $NO_3^-$ ions in a complex dispersion liquid when the complex dispersion liquid is positioned on the surface.

[Table 1]

|    | C    | N    | O     | Si    | Ag   |
|----|------|------|-------|-------|------|
| M1 | 0.00 | 0.00 | 34.36 | 65.42 | 0.22 |
| M2 | 0.00 | 0.00 | 28.83 | 70.29 | 0.88 |
| M3 | 0.00 | 0.00 | 20.98 | 78.88 | 0.14 |
| M4 | 0.00 | 0.00 | 18.51 | 80.87 | 0.63 |

Compositions of New Oxide Layer Formed on Si Together with Ag/PPy Complex
(Unit: at%)

<Diffusion characteristics of Ag/PPy with respect to various barriers>

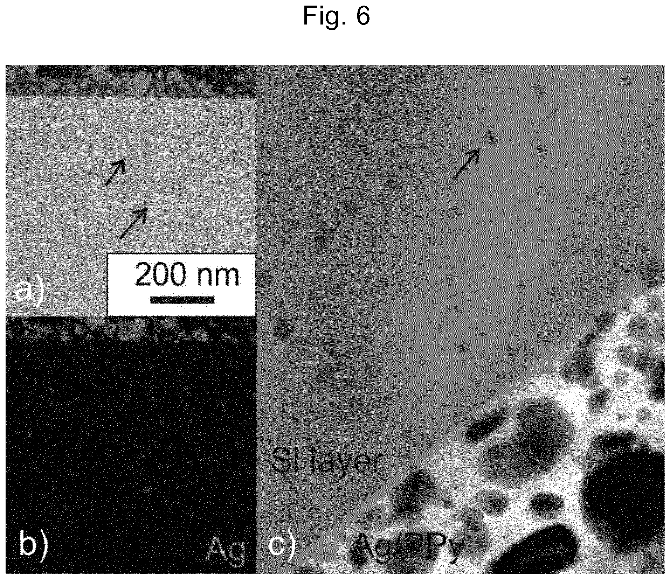

From the test on the interface between the Si oxide barrier layer and Ag/PPy, the following result is shown. In the coating of the layer having a thickness of 10 nm, almost no improvement in diffusion prevention was observed. The element map represented that Ag broke through the SiOx barrier. As shown in Figs. 6(a) and 6(b), Ag particles were diffused into the substrate up to a depth of 600 nm. From the diffraction pattern measurement on the substrate shown in Fig. 6(b), pure Si was shown in a bright part in Fig. 6(b) and diffused Ag was shown in a dark part in Fig. 6(b).

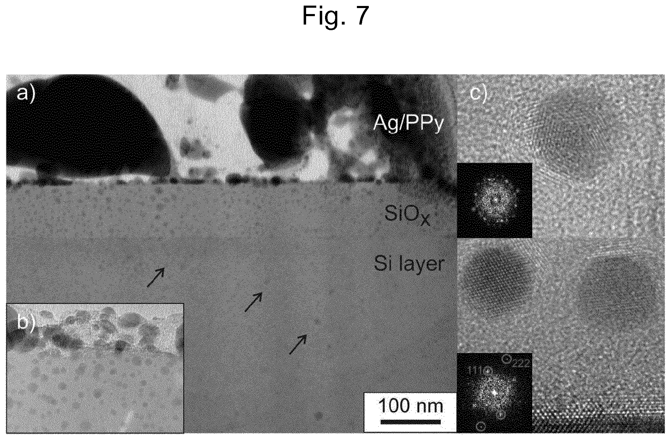

The oxide layer having a thickness of 50 nm and the oxide layer having a thickness of 100 nm were coated, and as a result, slight improvement was observed. In these cases, as shown in Fig. 7(a), Ag diffusion was observed in the Si layer up to depths of about 100 nm and 50 nm. That is, regardless of whether the thickness of the oxide layer was 50 nm or 100 nm, the total penetration depth from the interface between Ag/PPy and the substrate (Si layer coated with the oxide layer) into the substrate was 150 nm. Accordingly, it was speculated that the limit of the penetration depth from the interface between Ag/PPy and the substrate was 150 nm. Only a small amount of particles were separately diffused up to the depth lower than the speculated limit of the penetration depth. In these cases, the Ag amount of particles confirmed in Si (dark spot) is as small as less than 5 at%, but the Ag amount in the bright position is zero. When Ag particles were tested, it was found that Ag in the oxide layer was Ag having a crystalline structure. Herein, as shown in Fig. 7(b), the size of particles was significantly decreased and was measured to be in a range of 2 nm to 6 nm. As shown in Fig. 7(c), from the FFT diffraction analysis of Ag particles in the inner portion of the oxide layer in the HRTEM image, it was found that, in most cases, the FCC structure of the single crystal is shown, but some particles are poly crystals. The transfer of Ag particles is caused by particles passing through a part, which is weakened by broken Si-O-Si bridge, in the lattice and being introduced into the oxide (Non Patent Literatures 37 and 38). When the original Ag cluster in the complex material is a relatively large single crystal or poly crystal, Ag particles to be introduced into the oxide layer are most probably small fractions of crystalline grains (alternatively, in the case of a poly crystal, derived from crystalline grains of metallic silver in the complex at the position closest to the interface of the complex/oxide), and introduced into the oxide layer to become independent single-crystalline particles. In a case where the original Ag particles in the complex have the size in a range of 2 nm to 6 nm as above and the whole particles can pass through the complex/oxide interface without any structural change, particles remain as poly crystals in the oxide. This hypothesis is supported by a ratio of the single crystal to the poly crystal in two layers. That is, in the complex, most nano-sized particles are poly crystals and most of relatively large particles are single crystals or have a small number of crystal orientations; however, a large number of nanoparticles in the oxide layer are single crystals.

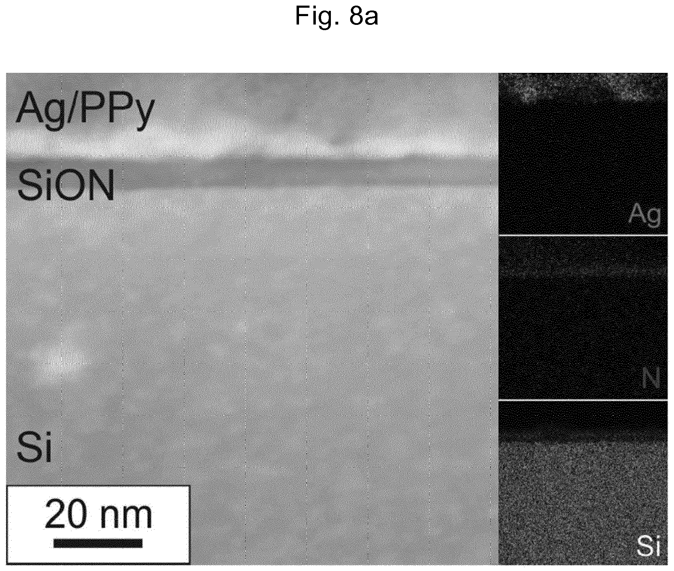

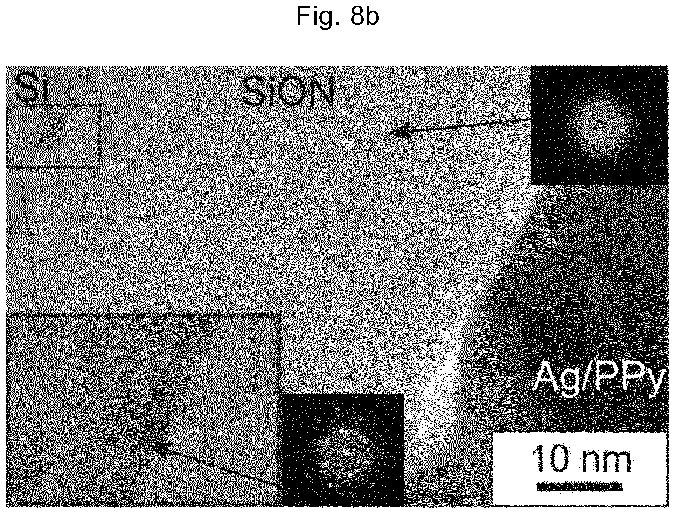

When the diffusion resistance effect of the Si oxynitride barrier layer was investigated, SiON-1 and SiON-2 (collectively referred to as SiON) both exhibited similar favorable barrier characteristic with respect to silver and this barrier characteristic was at a similar level to that known in the case of SiNx. The Ag diffusion was prevented by the SiON layer having a thickness of 10 nm. The reason for this is that from the results of EDX and diffraction measurement, as shown in Figs. 8a and 8b, the trace of the Ag diffusion was not observed in Si and the Si oxide layer.

<Adhesiveness of Ag/PPy complex on various barriers>

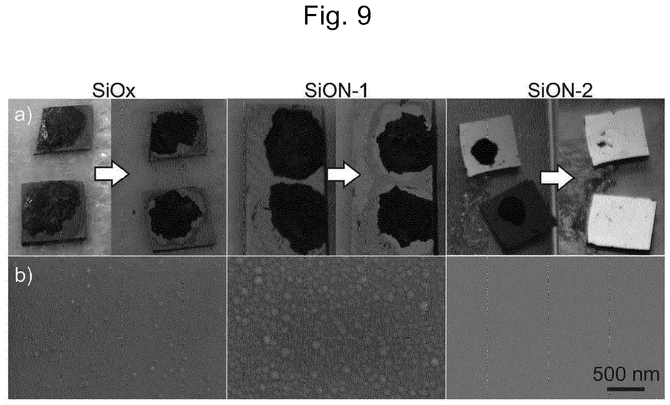

Herein, adhesiveness of the Ag/PPy complex to three types of substrates (a substrate with an SiOx barrier layer, a substrate with an SiON-1 barrier layer, and a substrate with an SiON-2 barrier layer) was evaluated by a peeling test. Fig. 9(a) shows surfaces of a test target sample before a peeling test (left side) and after the peeling test (right side). As understood from this drawing, the sufficient amount (> 90%) of the complex remained on the surface of the sample in SiON-1 and SiOx. On the other hand, in SiON-2, most of the complex was peeled off from the surface of the sample by an adhesive cellophane tape, and thus SiON-2 did not pass this test.

Fig. 9(b) shows SEM images representing the morphology of the surfaces of three types of substrates with barrier layers. From these SEM images, the SiOx barrier layer had slightly large surface roughness, the SiON-1 barrier layer had large surface roughness, and average protrusion heights were 40 nm and 60 nm, respectively. On the other hand, SiON-2 had a significantly smooth surface. The morphology of the surface oxide on metal plays a considerable role in the strength of the metal-polymer bond. Herein, the porous structure or roughness of the microscopic surface is mechanically coupled with a polymer to form a significantly strong bond as compared to the case of the smooth surface (Non Patent Literatures 39 and 40).

From measurement using XPS, it was confirmed that these layers are amorphous silicon oxynitrides (provided that, SiOx is amorphous silicon oxide) having the following composition: SiON-1: $Si_{55}N_{40}O_5$, SiON-2: $Si_{53}N_{45}O_2$, and SiOx: $Si_2O_3$. In the polymer/metal interface, chemical bonding occurs between the metal substrate and the polymer, and adhesiveness between the metal substrate and the polymer depends on formation of a primary bond and a secondary bond in the interface. In addition, oxygen on the metal surface has a huge effect on bond line strength (Non Patent Literature 41). When moisture is absorbed, the formation of a hydroxyl group which may react with a polar group in an adhesive is induced (Non Patent Literature 42). Based on the surfaces of SiON-1 and SiOx barrier layers having a relatively large oxygen amount and large roughness, it is described that Ag/PPy has favorable adhesiveness to these surfaces. In addition to this, regarding SiOx, the Ag diffusion into the barrier layer and the substrate helps adhesion of the complex (although this is not desirable phenomenon in terms of reliability issue). The smooth surface of SiON-2 and a small oxygen amount in SiON-2 become causes of poor adhesiveness to Ag/PPy.

According to the present invention, in a case where Ag/PPy is used as a via filling material, the aforementioned problem of the via of TSV is solved by the SiON-1 barrier layer having a small thickness of 10 nm. When the nitrogen amount of Si oxynitride is large, a complete Ag barrier layer is obtained; however, in order to obtain favorable adhesiveness to the Ag/PPy material, it is preferable to have a proper oxygen amount and large surface roughness. That is, when oxygen in silicon oxynitride is decreased, its Ag diffusion prevention property is increased since the characteristics of the silicon oxynitride becomes closer to those of silicon nitride, while its adhesiveness to the Ag/PPy complex is decreased. On the other hand, when oxygen is increased, adhesiveness is increased since the characteristics of the silicon oxynitride becomes closer to those of silicon oxide, while its Ag diffusion prevention property is decreased. The range, in which both of Ag diffusion prevention property and adhesiveness to the Ag/PPy complex can be satisfied, of the oxygen amount in silicon oxynitride is 4.2 at% to 37.5 at% and more preferably 5 at% to 20 at%.

<Conclusion>

By using a barrier layer, the aforementioned Ag/PPy complex can be used as a favorable candidate of a conductive filling material for TSV using high-speed and inexpensive processes. That is, according to the present invention, vertical electrical wiring having high reliability for a 3D semiconductor device can be realized easily at low cost.

In the above description, the interface structure of the complex/the barrier layer/the Si substrate has been clarified. In addition, an optimized barrier layer having both of favorable adhesiveness and diffusion barrier characteristics has been established.

After the Ag/PPy complex is deposited on the Si substrate (having a native oxide film), Ag derived from the Ag cluster in this complex is diffused toward the Si layer. The Ag segregation is observed near dislocation in the Si substrate. Ag/PPy forms, on the Si substrate, an Si oxide having a thickness about five times the thickness of the native oxide film formed under an external air condition.

The diffusion of C into the Si substrate was not observed in any samples (that is, neither in Si with a native oxide film nor in Si coated with an SiOx or SiOxNy barrier).

Ag from this complex can pass through mSiOx having a thickness of 100 nm and can move, but as the thickness of this barrier layer is increased, the amount of Ag to be diffused into Si is decreased. The N components of SiON-1 and SiON-2 pass through the layer having a thickness as small as 10 nm so as to completely prevent the diffusion of Ag from being directed toward Si. Since SiON-2 does not have a proper oxygen content and the surface thereof is smooth, SiON-2 has poor adhesiveness; however, SiON-1 containing 5 at% of O and having sufficient surface roughness becomes a suitable barrier layer material for TSV.

The Ag cluster in PPy has a single-crystalline structure or a poly-crystalline structure obtained by repeated twinning and the size thereof may be changed between several nm to several tens of $\mu$m. However, while Ag passes through the Si oxide layer and is diffused, the size of Ag particles is decreased to 2 nm to 6 nm, and in many cases, Ag particles will have a single-crystalline structure.

**Claims**

1. A silver diffusion barrier material comprising silicon oxynitride with an oxygen content ranging from 4.2 at% to 37.5 at%.

2. A silver diffusion barrier comprising the silver diffusion prevention material according to claim 1.

3. The silver diffusion barrier according to claim 2, being formed on a silicon substrate.

4. The silver diffusion barrier according to claim 3, being brought into contact with a material containing silver.

5. The silver diffusion barrier according to any one of claims 2 to 4, having a thickness of 10 nm or more.

6. A semiconductor device in which a plurality of silicon chips is vertically stacked by through-silicon vias, the semiconductor device comprising:

   the silver diffusion barrier according to any one of claims 2 to 5 provided on an inner surface of the via for achieving electrical connection between the plurality of silicon chips.

7. The semiconductor device according to claim 6, wherein a silver/polypyrrole complex material is filled in the via provided with the silver diffusion layer.

Fig. 1

EP 3 144 964 A1

# Fig. 2

3.51 nm

5 nm

Ag particle

# Fig. 3

Fig. 4

EP 3 144 964 A1

Fig. 5

15

## Fig. 6

# Fig. 7

Fig. 8a

Fig. 8b

# Fig. 9

## INTERNATIONAL SEARCH REPORT

| | International application No. |
|---|---|
| | PCT/JP2015/063860 |

**A. CLASSIFICATION OF SUBJECT MATTER**
*H01L21/3205*(2006.01)i, *C08K3/08*(2006.01)i, *C08L65/00*(2006.01)i,
*H01L21/768*(2006.01)i, *H01L23/522*(2006.01)i, *H01L23/532*(2006.01)i,
*H01L25/065*(2006.01)i, *H01L25/07*(2006.01)i, *H01L25/18*(2006.01)i
According to International Patent Classification (IPC) or to both national classification and IPC

**B. FIELDS SEARCHED**

Minimum documentation searched (classification system followed by classification symbols)
H01L21/3205, C08K3/08, C08L65/00, H01L21/768, H01L23/522, H01L23/532,
H01L25/065, H01L25/07, H01L25/18

Documentation searched other than minimum documentation to the extent that such documents are included in the fields searched
Jitsuyo Shinan Koho        1922-1996   Jitsuyo Shinan Toroku Koho   1996-2015
Kokai Jitsuyo Shinan Koho   1971-2015   Toroku Jitsuyo Shinan Koho   1994-2015

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2007-109736 A (NEC Electronics Corp.),<br>26 April 2007 (26.04.2007),<br>paragraphs [0009] to [0010]<br>& US 2007/0082488 A1 | 1-5<br>6<br>7 |
| Y<br>A | JP 2012-119685 A (Samsung Electronics Co.,<br>Ltd.),<br>21 June 2012 (21.06.2012),<br>paragraph [0024]<br>& US 2012/0133048 A1    & DE 102011054908 A1<br>& KR 10-2012-0058114 A   & CN 102479771 A<br>& TW 201230281 A | 6<br>7 |

☒  Further documents are listed in the continuation of Box C.       ☐  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 15 June 2015 (15.06.15) | 23 June 2015 (23.06.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | |
| | Telephone No. |

Form PCT/ISA/210 (second sheet) (July 2009)

**INTERNATIONAL SEARCH REPORT**

International application No.

PCT/JP2015/063860

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2005-166502 A  (Toppan Forms Co., Ltd.), 23 June 2005 (23.06.2005), paragraphs [0015], [0023] & US 2006/0057451 A1    & WO 2004/067637 A1 & EP 1589074 A1          & CA 2513596 A1 & TW 200422338 A          & KR 10-2005-0093848 A & AU 2004207106 A        & HK 1077319 A | 1-7 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MOTOYOSHI, M.** Through-Silicon Via (TSV). *Proc. IEEE,* 2009, vol. 97 (1), 43-48
- **OKORO, C. ; VANSTREELS, K. ; LABIE, R. ; LUHN, O. ; VANDEVELDE, B. ; VERLINDEN, B. ; VANDEPITTE, D.** Influence of annealing conditions on the mechanical and microstructural behavior of electroplated Cu-TSV. *J. Micromech. Microeng,* 2010, vol. 20 (4), 045032
- **KIM, B. ; SHARBONO, C. ; RITZDORF, T. ; SCHMAUCH, D.** In Factors affecting copper filling process within high aspect ratio deep vias for 3D chip stacking. *Proc. Electronic Components and Technology Conference 56th,* 2006, 6
- **SHI, S. ; WANG, X. ; XU, C. ; YUAN, J. ; FANG, J. ; LIU, S.** Simulation and fabrication of two Cu TSV electroplating methods for wafer-level 3D integrated circuits packaging. *Sensor. Actuator. A: Physical,* 2013, vol. 203 (0), 52-61
- **STEJSKAL, J.** Conducting polymer-silver composites. *Chem. Pap.,* 2013, vol. 67 (8), 814-848
- **FUJII, S. ; MATSUZAWA, S. ; HAMASAKI, H. ; NAKAMURA, Y. ; BOULEGHLIMAT, A. ; BUURMA, N. J.** Polypyrrole-Palladium Nanocomposite Coating of Micrometer-Sized Polymer Particles Toward a Recyclable Catalyst. *Langmuir,* 2011, vol. 28 (5), 2436-2447
- **TAMIL SELVAN, S.** Novel nanostructures of gold-polypyrrole composites. *Chem. Commun.,* 1998, 351-352
- **HENRY, M. C. ; HSUEH, C.-C. ; TIMKO, B. P. ; FREUND, M. S.** Reaction of Pyrrole and Chlorauric Acid A New Route to Composite Colloids. *J. Electrochem. Soc.,* 2001, vol. 148 (11), D155-D162
- **KAWAKITA, J. ; CHIKYOW, T.** Fast Formation of Conductive Material by Simultaneous Chemical Process for Infilling Through-Silicon Via. *Jpn J Appl Phys,* vol. 51, 06FG11
- **JUNG, Y. J. ; GOVINDAIAH, P. ; CHOI, S. W. ; CHEONG, I. W. ; KIM, J. H.** Morphology and conducting property of Ag/poly(pyrrole) composite nanoparticles: Effect of polymeric stabilizers. *Synth. Met.,* 2011, vol. 161 (17-18), 1991-1995
- **SHI, Z. ; WANG, H. ; DAI, T. ; LU, Y.** Room temperature synthesis of Ag/polypyrrole core-shell nanoparticles and hollow composite capsules. *Synth. Met.,* 2010, vol. 160 (19-20), 2121-2127

- **DALLAS, P. ; NIARCHOS, D. ; VRBANIC, D. ; BOUKOS, N. ; PEJOVNIK, S. ; TRAPALIS, C. ; PETRIDIS, D.** Interfacial polymerization of pyrrole and in situ synthesis of polypyrrole/silver nanocomposites. *Polymer,* 2007, vol. 48 (7), 2007-2013
- **ZHAO, C. ; ZHAO, Q. ; ZHAO, Q. ; QIU, J. ; ZHU, C. ; GUO, S.** Preparation and optical properties of Ag/PPy composite colloids. *J. Photoch. Photobio,* 2007, vol. 187 (2-3), 146-151
- **IJERI, V. S. ; NAIR, J. R. ; GERBALDI, C. ; GONNELLI, R. S. ; BODOARDO, S. ; BONGIOVANNI, R. M.** An elegant and facile single-step UV-curing approach to surface nano-silvering of polymer composites. *Soft Matter,* 2010, vol. 6 (19), 4666-4668
- **KABIR, L. ; MANDAL, A. R. ; MANDAL, S. K.** Humidity-sensing properties of conducting polypyrrole-silver nanocomposites. *J. Exp. Nanosci.,* 2008, vol. 3 (4), 297-305
- **KATE, K. H. ; DAMKALE, S. R. ; KHANNA, P. K. ; JAIN, G. H.** Nano-Silver Mediated Polymerization of Pyrrole: Synthesis and Gas Sensing Properties of Polypyrrole (PPy)/Ag Nano-Composite. *J. Nanosci. Nanotechno.,* 2011, vol. 11 (9), 7863-7869
- **QIN, X. ; LU, W. ; LUO, Y. ; CHANG, G. ; SUN, X.** Preparation of Ag nanoparticle-decorated polypyrrole colloids and their application for H2O2 detection. Electrochem. *Commun.,* 2011, vol. 13 (8), 785-787
- **YAO, T. ; WANG, C. ; WU, J. ; LIN, Q. ; LV, H. ; ZHANG, K. ; YU, K. ; YANG, B.** Preparation of raspberry-like polypyrrole composites with applications in catalysis. *J. Colloid Interface Sci.,* 2009, vol. 338 (2), 573-577
- **SHI, Z. ; ZHOU, H. ; QING, X. ; DAI, T. ; LU, Y.** Facile fabrication and characterization of poly(tetrafluoroethylene)@polypyrrole/nano-silver composite membranes with conducting and antibacterial property. *Appl. Surf. Sci.,* 2012, vol. 258 (17), 6359-6365
- **FIROZ BABU, K. ; DHANDAPANI, P. ; MARUTHAMUTHU, S. ; ANBU KULANDAINATHAN, M.** One pot synthesis of polypyrrole silver nanocomposite on cotton fabrics for multifunctional property. *Carbohydr. Polym.,* 2012, vol. 90 (4), 1557-1563
- **B. HORVATH ; J. KAWAKITA ; CHIKYOW, T.** Through silicon via filling methods with metal/polymer composite for three-dimensional LSI. *Jpn J Appl Phys,* 2014

- **KAWAKITA, J. ; HASHIMOTO, Y. ; CHIKYOW, T.** Strong Adhesion of Silver/Polypyrrole Composite onto Plastic Substrates toward Flexible Electronic. *Jpn J Appl Phys,* vol. 52, 06GG12
- **SEINO, K. ; SCHMIDT, W. G. ; FURTHMULLER, J. ; BECHSTEDT, F.** Chemisorption of pyrrole and polypyrrole on Si(001). *Phys. Rev. B,* 2002, vol. 66 (23), 235323
- **COFFA, S. ; POATE, J. M. ; JACOBSON, D. C. ; FRANK, W. ; GUSTIN, W.** Determination of diffusion mechanisms in amorphous silicon. *Phys. Rev. B,* 1992, vol. 45 (15), 8355-8358
- **KAWAMOTO, K. ; MORI, T. ; KUJIME, S. ; OURA, K.** Observation of the diffusion of Ag atoms through an a-Si layer on Si(111) by low-energy ion scattering. *Surf. Sci.,* 1996, vol. 363 (1-3), 156-160
- **ROLLERT, F. ; STOLWIJK, N. A. ; MEHRER, H.** Solubility, diffusion and thermodynamic properties of silver in silicon. *J. Phys. D: Appl. Phys.,* 1987, vol. 20 (9), 1148
- **KLUMPP, A. ; RAMM, P. ; WIELAND, R.** 3D-integration of silicon devices: A key technology for sophisticated products. *Proc. Design, Automation & Test in Europe Conference & Exhibition (DATE), 2010, 8-12 March,* 2010, 1678-1683
- **SAGE, S. ; JOHN, P. ; DOBRITZ, S. ; BOERNGE, J. ; VITIELLO, J. ; BOETTCHER, M.** Investigation of different methods for isolation in through silicon via for 3D integration. *Microelectron. Eng.,* 2013, vol. 107 (0), 61-64
- Lead free metallisation paste for crystalline silicon solar cells: from model to results. **HOORNSTRA, J. ; SCHUBERT, G. ; BROEK, K. ; GRANEK, F. ; LEPRINCE, C.** Proc. Photovoltaic Specialists Conference. IEEE, 03 January 2005, 1293-1296
- Heavy Metals - Advances in Research and Application. ScholarlyEditions, 2013
- **SURYANARAYANA, D. ; MITTAL, K. L.** Effect of polyimide thickness on its adhesion to silicon nitride substrate with and without adhesion promoter. *J. Appl. Polym. Sci.,* 1985, vol. 30 (7), 3107-3111
- **MCBRAYER, J. D. ; SWANSON, R. M. ; SIGMON, T. W.** Diffusion of Metals in Silicon Dioxide. *J. Electrochem. Soc.,* 1986, vol. 133 (6), 1242-1246
- **KIM, H.-K. ; CHO, C.-K.** Transparent SiON/Ag/SiON multilayer passivation grown on a flexible polyethersulfone substrate using a continuous roll-to-roll sputtering system. *Nanoscale Res. Lett.,* 2012, vol. 7 (69), 1-6
- *JIS Z1522 standard,* 2009
- **HOFMEISTER, H.** Fivefold Twinned Nanoparticles. *Enc. Nanosci. Nanotech.,* 2003, vol. 3, 431-452
- **MORITA, M. ; OHMI, T. ; HASEGAWA, E. ; KAWAKAMI, M. ; OHWADA, M.** Growth of native oxide on a silicon surface. *J. Appl. Phys.,* 1990, vol. 68 (3), 1272-1281
- **REVESZ, A. G. ; EVANS, R. J.** Kinetics and mechanism of thermal oxidation of silicon with special emphasis on impurity effects. *J. Phys. Chem. Solids,* 1969, vol. 30 (3), 551-564
- **DALLAPORTA, H. ; LIEHR, M. ; LEWIS, J. E.** Silicon dioxide defects induced by metal impurities. *Phys. Rev. B,* 1990, vol. 41 (8), 5075-5083
- **VENABLES, J. D.** Adhesion and durability of metal-polymer bonds. *J. Mat. Sci.,* 1984, vol. 19 (8), 2431-2453
- **BIJLMER, P. F. A.** Influence of Chemical Pretreatments on Surface Morphology and Bondability of Aluminium. *J. Adhesion,* 1973, vol. 5 (4), 319-331
- **G. RAMARATHNAM ; M. LIBERTUCCI ; M. M. SADOWSKI ; NORTH, T. H.** Joining of Polymers to Metal. *Welding Journal,* 1992, vol. 71 (12), 483-490
- **KOZMA, L. ; OLEFJORD, I.** Surface treatment of steel for structural adhesive bonding. *Mater. Sci. Technol.,* 1987, vol. 3 (11), 954-962